# EUROPEAN PATENT APPLICATION

(11) **EP 4 756 866 A1**
(43) Date of publication of application: **10.06.2026**
(21) Application number: 24848622.7
(22) Date of filing: 30.04.2024
(51) Int. Cl.: H01L 21/3063, C25F 3/12, C25F 3/14

(54) **SUBSTRATE PROCESSING DEVICE**

(30) Priority: 28.07.2023 JP 2023123346
(71) Applicant: SCREEN Holdings Co., Ltd., Kyoto-shi, Kyoto 602-8585 (JP)
(72) Inventor: MORITA, Kosei, Kyoto-shi, Kyoto 602-8585 (JP)
(74) Representative: Kilian Kilian & Partner mbB
(86) International application number: PCT/JP2024/016702
(87) International publication number: WO 2025/027961

(57) **Abstract**

A substrate processing apparatus (1) includes a substrate holder for holding a disk-like substrate (9), an electrode unit (5) facing a target portion during etching, which is part of a peripheral portion (93) of the substrate (9), and having a first electrode (51) and a second electrode (52), a processing liquid filling part (6) for forming a liquid-filled state in which a processing liquid fills a space among the target portion, the first electrode (51), and the second electrode (52) by discharging the processing liquid from a discharge port (611), a rotator for rotating the substrate (9) relative to the electrode unit (5), to thereby move the target portion in the peripheral portion (93) in a circumferential direction of the substrate (9), and a power supply (50) for applying a voltage to between the first electrode (51) and the second electrode (52). It is thereby possible to appropriately remove a metal film (96) in the peripheral portion (93) of the substrate (9).

## Description

### TECHNICAL FIELD

The present invention relates to a substrate processing apparatus.

### [CROSS REFERENCE TO RELATED APPLICATION]

The present application claims the benefit of priority to Japanese Patent Application No. 2023-123346 filed on July 28, 2023, the content of which is incorporated herein by reference in its entirety.

### BACKGROUND ART

In a process of manufacturing a semiconductor substrate (hereinafter, referred to simply as a "substrate"), conventionally, various processings are performed on the substrate. In Japanese Patent Application Laid Open Gazette No. 2002-353191 (Document 1) and Japanese Patent Application Laid Open Gazette No. 2003-324091 (Document 2), for example, disclosed is a method of etching a metal film, in which a metal film on a substrate is used as an electrode and a space between the metal film and another electrode is filled with an electrolyte solution while a voltage is applied to between the electrodes. In a substrate processing apparatus disclosed in Japanese Patent Application Laid Open Gazette No. 2021-158300 (Document 3) and Japanese Patent Application Laid Open Gazette No. 2023-8390 (Document 4), a processing liquid is discharged by a processing liquid supplier to a plurality of portions having different positions on a substrate on which a noble metal film is formed, and a positive electrode comes into contact with the processing liquid at one portion and a negative electrode comes into contact with the processing liquid on a different portion, to thereby etch the noble metal film on the substrate. Thus, in a case where two different contacts are provided for the positive electrode and the negative electrode, a current is carried only to the noble metal film which is an etching target between the contacts, and it thereby becomes possible to increase the etching rate.

In the method in which the two different contacts are provided for the positive electrode and the negative electrode, as shown in Documents 3 and 4, an etching reaction occurs at the contact on the negative electrode side out of the two contacts. Therefore, in a case where etching is performed on a metal film in a peripheral portion (bevel part or the like) while a substrate is rotated, when the etching proceeds to some degree, the positive electrode faces a region from which the metal film has been removed and the contact on the positive electrode side does not come into contact with the metal film. As a result, no current is carried between the positive electrode and the negative electrode and the etching does not proceed, and it is not possible to appropriately remove the metal film in the peripheral portion.

### SUMMARY OF THE INVENTION

The present invention is intended for a substrate processing apparatus, and it is an object of the present invention to appropriately remove a metal film in a peripheral portion of a substrate.

A first aspect of the present invention is intended for a substrate processing apparatus for performing etching on a peripheral portion of a substrate, and the substrate processing apparatus according to the first aspect includes a substrate holder for holding a disk-like substrate, an electrode unit facing a target portion during etching, and having a first electrode and a second electrode, the target portion being part of the peripheral portion of the substrate, a processing liquid filling part for forming a liquid-filled state in which a processing liquid fills a space among the target portion, the first electrode, and the second electrode by discharging the processing liquid from a discharge port, a rotator for rotating the substrate relative to the electrode unit, to thereby move the target portion in the peripheral portion in a circumferential direction of the substrate, and a power supply for applying a voltage to between the first electrode and the second electrode.

According to the present invention, it is possible to appropriately remove the metal film in the peripheral portion of the substrate.

A second aspect of the present invention is intended for the substrate processing apparatus according to the first aspect, and in the substrate processing apparatus according to the second aspect, the first electrode is positioned on a side of one main surface of the substrate and the second electrode is positioned on a side of the other main surface of the substrate.

A third aspect of the present invention is intended for the substrate processing apparatus according to the second aspect, and in the substrate processing apparatus according to the third aspect, the first electrode and the second electrode at least partially overlap each other as viewed along a direction perpendicular to the substrate.

A fourth aspect of the present invention is intended for the substrate processing apparatus according to the second aspect (or the second or third aspect), and in the substrate processing apparatus according to the fourth aspect, the first electrode has a facing surface substantially parallel to the one main surface and the facing surface of the first electrode faces the substrate on the side of the one main surface of the substrate and the second electrode has a facing surface substantially parallel to the other main surface and the facing surface of the second electrode faces the substrate on the side of the other main surface of the substrate.

A fifth aspect of the present invention is intended for the substrate processing apparatus according to the fourth aspect, and in the substrate processing apparatus according to the fifth aspect, the substrate is held in a horizontal posture by the substrate holder and the facing surface of the second electrode positioned on a lower surface side of the substrate is larger than the facing surface of the first electrode positioned on an upper surface side of the substrate.

A sixth aspect of the present invention is intended for the substrate processing apparatus according to the fifth aspect, and in the substrate processing apparatus according to the sixth aspect, the second electrode is a positive electrode.

A seventh aspect of the present invention is intended for the substrate processing apparatus according to the fourth aspect, and in the substrate processing apparatus according to the seventh aspect, the electrode unit has an insulating member to which the first electrode and the second electrode are fixed, the insulating member being disposed between the first electrode and the second electrode outside the peripheral portion of the substrate and the processing liquid filling part supplies the processing liquid from the discharge port to a space surrounded by the insulating member, the first electrode, and the second electrode.

An eighth aspect of the present invention is intended for the substrate processing apparatus according to the first aspect (or any one of the first to third aspects), and in the substrate processing apparatus according to the eighth aspect, the substrate is held in a horizontal posture by the substrate holder, the processing liquid filling part includes a nozzle having the discharge port, being disposed on an upper surface side of the substrate, the nozzle discharges the processing liquid from the discharge port toward the target portion, and the first electrode is disposed inside the nozzle and the second electrode is disposed on a lower surface side of the substrate.

A ninth aspect of the present invention is intended for the substrate processing apparatus according to any one of the first to eighth aspects, and the substrate processing apparatus according to the ninth aspect further includes an electrode moving mechanism for moving the electrode unit in a radial direction of the substrate.

A tenth aspect of the present invention is intended for the substrate processing apparatus according to the ninth aspect, and in the substrate processing apparatus according to the tenth aspect, a member having the discharge port in the processing liquid filling part and the electrode unit are fixed to each other and the electrode moving mechanism moves the member of the processing liquid filling part together with the electrode unit.

These and other objects, features, aspects and advantages of the present invention will become more apparent from the following detailed description of the present invention when taken in conjunction with the accompanying drawings.

### BRIEF DESCRIPTION OF DRAWINGS

FIG. 1 is a view showing a layout of a substrate processing system;
FIG. 2 is a view showing a configuration of a substrate processing apparatus in accordance with a first preferred embodiment;
FIG. 3 is a cross-sectional view showing a vicinity of an electrode unit;
FIG. 4A is a flowchart showing an operation flow of substrate processing in the substrate processing apparatus;
FIG. 4B is a flowchart showing an operation flow of the substrate processing in the substrate processing apparatus;
FIG. 5 is a view showing a substrate processing apparatus in Comparative Example;
FIG. 6 is a view used for explaining substrate processing in the substrate processing apparatus in Comparative Example;
FIG. 7 is a view used for explaining the substrate processing in the substrate processing apparatus in Comparative Example;
FIG. 8 is a view showing another example of the substrate processing apparatus;
FIG. 9 is a plan view showing another example of the electrode unit;
FIG. 10 is a cross-sectional view showing another example of the electrode unit;
FIG. 11 is a view showing an electrode unit and a processing liquid nozzle in accordance with a second preferred embodiment;
FIG. 12 is a plan view showing an electrode unit and part of a processing liquid filling part in accordance with a third preferred embodiment;
FIG. 13 is a cross-sectional view showing the electrode unit and the like;
FIG. 14 is a cross-sectional view showing another example of the substrate processing apparatus;
FIG. 15 is a cross-sectional view showing another example of the electrode unit;
FIG. 16 is a plan view showing another example of the electrode unit; and
FIG. 17 is a plan view showing another example of a rotator.

### DESCRIPTION OF EMBODIMENTS

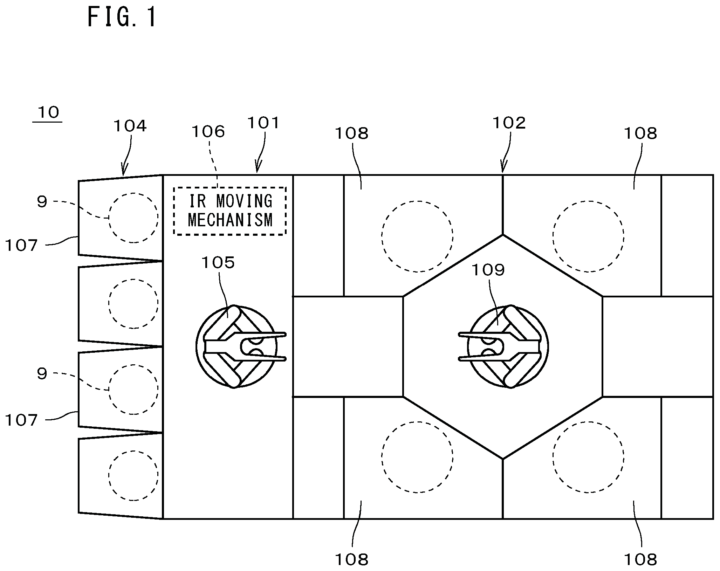

FIG. 1 is a view showing a layout of a substrate processing system 10. The substrate processing system 10 is a system for processing a disk-like semiconductor substrate 9 (hereinafter, referred to simply as a "substrate 9"). The substrate processing system 10 includes an indexer block 101 and a processing block 102 coupled with the indexer block 101.

The indexer block 101 includes a carrier holder 104, an indexer robot 105, and an IR moving mechanism 106. The carrier holder 104 holds a plurality of carriers 107 each of which can accommodate a plurality of substrates 9. The plurality of carriers 107 (e.g., FOUPs) are held by the carrier holder 104 while being arranged in a predetermined carrier arrangement direction. The IR moving mechanism 106 moves the indexer robot 105 in the carrier arrangement direction. The indexer robot 105 performs an unloading operation for unloading the substrate 9 from the carrier 107 and a loading operation for loading the substrate 9 into the carrier 107. The substrate 9 is transferred in a horizontal posture by the indexer robot 105.

The processing block 102 includes a plurality of (e.g., four or more) processing units 108 for processing the substrate 9 and a center robot 109. The plurality of processing units 108 are so arranged as to surround the center robot 109 in a plan view. In the plurality of processing units 108, various processings are performed on the substrate 9. The substrate processing apparatus described later is one of the plurality of processing units 108. The center robot 109 passes the substrate 9 from/to the indexer robot 105. Further, the center robot 109 performs a loading operation for loading the substrate 9 into the processing unit 108 and an unloading operation for unloading the substrate 9 from the processing unit 108. The center robot 109 transfers the substrate 9 among the plurality of processing units 108. The substrate 9 is transferred in the horizontal posture by the center robot 109.

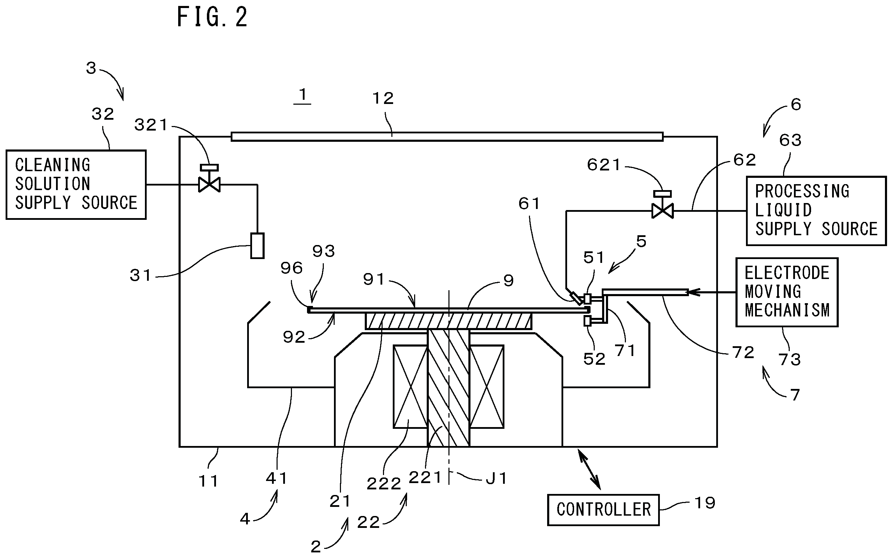

FIG. 2 is a view showing a configuration of a substrate processing apparatus 1 in accordance with the first preferred embodiment. In FIG. 2, part of the configuration of the substrate processing apparatus 1 is shown in a cross section taken by a plane including a predetermined central axis J1. The substrate processing apparatus 1 is a single-substrate processing apparatus for processing the substrate 9 one by one, and performs electrolytic etching on a peripheral portion 93 of the substrate 9. The peripheral portion 93 of the substrate 9 includes an edge end surface (apex), bevel parts, and vicinities of the bevel parts on an upper surface 91 and a lower surface 92 described later.

The substrate processing apparatus 1 includes a spin chuck 2, a cleaning solution supplier 3, a cup part 4, an electrode unit 5, a processing liquid filling part 6, an electrode moving part 7, a housing 11, and a controller 19. The spin chuck 2, part of the cleaning solution supplier 3, the cup part 4, the electrode unit 5, part of the processing liquid filling part 6, and part of the electrode moving part 7 are accommodated in an internal space of the housing 11. A top cover portion of the housing 11 is provided with an airflow formation part 12 which supplies gas to the internal space and thereby forms an airflow flowing downward (i.e., downflow). As the airflow formation part 12, for example, used is an FFU (fan filter unit). The controller 19 is disposed outside the housing 11 and controls the constituent components of the substrate processing apparatus 1. The controller 19 is implemented when a computer having a CPU, a memory, and the like executes a predetermined program. Part of or the whole of the controller 19 may be implemented by a programmable logic controller (PLC) or the like.

The spin chuck 2 shown in FIG. 2 includes a chuck part 21 and a rotator 22. The chuck part 21 has a substantially disk-like shape around the central axis J1 extending substantially parallel to an up-and-down direction, and serves as a substrate holder for holding the substrate 9 in the horizontal posture from below. The chuck part 21 is, for example, a vacuum chuck and comes into contact with a center portion of a lower main surface 92 of the substrate 9 to adsorb the substrate 9. Typically, the diameter of the chuck part 21 is smaller than that of the substrate 9. The center of the substrate 9 on the chuck part 21 substantially overlaps the central axis J1. In the following description, on the substrate 9 held by the chuck part 21 in the horizontal posture, a lower-side main surface 92 is referred to as a "lower surface 92", and an upper-side main surface 91 is referred to as an "upper surface 91". Further, a radial direction and a circumferential direction with the central axis J1 as a center are referred to simply as a "radial direction" and a "circumferential direction", respectively. The radial direction is also a radial direction of the substrate 9 and the circumferential direction is also a circumferential direction of the substrate 9.

A metal film 96 to be processed in the substrate processing apparatus 1 is provided in the peripheral portion 93 of the substrate 9. The thickness of the metal film 96 is, for example, several tens nm. The metal film 96 is provided on the whole of or part of the peripheral portion 93. The metal film 96 has only to be present at least in the peripheral portion 93 and may be present in a region inside relative to the peripheral portion 93 on the upper surface 91 or the lower surface 92, as well as the peripheral portion 93. The metal film 96 may be spread substantially entirely on the upper surface 91 or the lower surface 92 of the substrate 9. In FIG. 2, the metal film 96 is indicated by a thick line. The metal film 96 contains, for example, ruthenium (Ru). The metal film 96 may be a film containing a compound of ruthenium, as well as a film of simple ruthenium. Further, the metal film 96 may be a film containing a metal other than ruthenium. In the present preferred embodiment, it is assumed that the metal film 96 contains ruthenium.

The rotator 22 is disposed below the chuck part 21. The rotator 22 rotates the substrate 9 together with the chuck part 21 around the central axis J1. The rotator 22 includes a shaft 221 and a motor 222. The shaft 221 is a substantially columnar or substantially cylindrical member around the central axis J1. The shaft 221 is extended in the up-and-down direction and is connected to a center portion of a lower surface of the chuck part 21. The motor 222 is an electric rotary motor for rotating the shaft 221. The rotator 22 may be a motor (e.g., a hollow motor or the like) having any other structure.

The cleaning solution supplier 3 includes a cleaning solution nozzle 31 and a cleaning solution supply source 32. The cleaning solution nozzle 31 is supported by a not-shown nozzle moving mechanism. The nozzle moving mechanism has, for example, a motor, a ball screw, and the like and moves the cleaning solution nozzle 31 substantially horizontally between a supply position above the substrate 9 and an escape position outside in the radial direction relative to the substrate 9. The cleaning solution nozzle 31 is connected to the cleaning solution supply source 32 through a cleaning solution line provided with a valve 321. The cleaning solution supply source 32 supplies a cleaning solution to the cleaning solution nozzle 31. The cleaning solution is, for example, pure water such as DIW (deionized water) or the like. The cleaning solution may be an organic solvent such as IPA or the like or any other type of liquid.

The cup part 4 includes a cup 41 and a not-shown cup up-and-down moving mechanism. The cup part 41 is an annular member around the central axis J1. The cup 41 is arranged around the substrate 9 and the chuck part 21 along the entire circumference in a circumferential direction to cover a side and a lower side of the substrate 9 and the chuck part 21. The cup 41 is a liquid receiving container for receiving a liquid spattering from the rotating substrate 9 toward the periphery. An inner surface of the cup 41 is formed of, for example, a water-repellent material. The cup 41 is at rest in the circumferential direction regardless of whether the substrate 9 is rotated or still. On a bottom of the cup 41, provided is a drainage port (not shown) for discharging the liquid received by the cup 41 to outside the housing 11.

The cup up-and-down moving mechanism moves the cup 41 relative to the chuck part 21 in the up-and-down direction. The cup up-and-down moving mechanism has, for example, a motor, an air cylinder, or the like as a drive source. By the cup up-and-down moving mechanism, the cup 41 is movable in the up-and-down direction between a processing position which is a position around the substrate 9 shown in FIG. 2 and the escape position below the processing position. The cup part 4 may have a plurality of cups 41 layered in the radial direction. In a case where the cup part 4 includes the plurality of cups 41, each of the plurality of cups 41 is independently movable in the up-and-down direction, and in accordance with the type of liquid spattering from the substrate 9, the plurality of cups 41 are switched and used to receive the liquid.

The electrode unit 5 includes a first electrode 51 and a second electrode 52. Each of the first electrode 51 and the second electrode 52 has a rod-like or columnar shape extending in the up-and-down direction. The diameter of each electrode 51 or 52 is, for example, not smaller than 2 mm and not larger than 20 mm, and preferably not larger than 4 mm. The material of each electrode 51 or 52 is, for example, platinum (Pt) or glassy carbon (vitreous carbon). As the material for the electrode 51 or 52, any other conductive material which makes it possible to appropriately perform later-described etching may be used.

As described later, the electrode unit 5 is supported by the electrode moving part 7, and during etching of the peripheral portion 93 of the substrate 9, the electrode unit 5 is positioned at the processing position facing part of the peripheral portion 93. In a state where the electrode unit 5 is disposed at the processing position, the first electrode 51 is positioned on the side of the upper surface 91 of the substrate 9 and the second electrode 52 is positioned on the side of the lower surface 92 of the substrate 9. In the present preferred embodiment, as viewed along the up-and-down direction, the first electrode 51 and the second electrode 52 have almost the same size and are disposed at the same position. In other words, in a plan view, substantially the whole of the first electrode 51 overlaps the whole of the second electrode 52. As described later, since etching of the metal film 96 is performed in a portion on the peripheral portion 93, which the electrode unit 5 faces, this portion will be referred to as a "target portion" hereinafter.

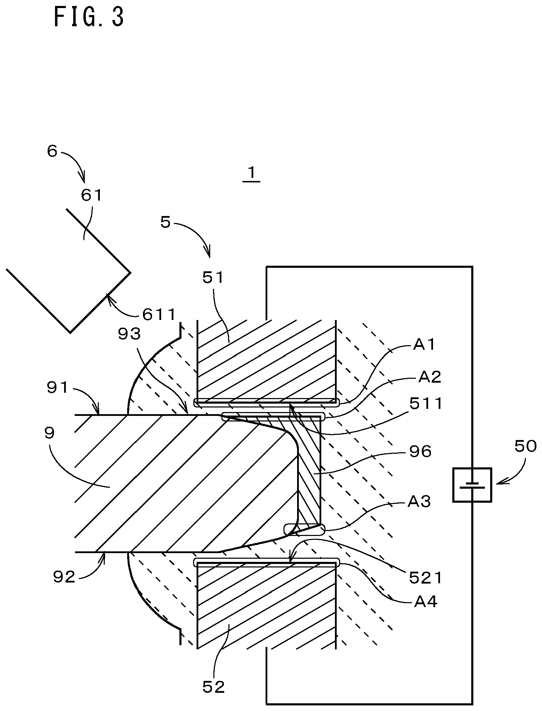

FIG. 3 is a cross-sectional view showing a vicinity of the electrode unit 5 and shows a cross section of the substrate 9, the first electrode 51, and the second electrode 52 taken by a plane including the central axis J1 and the center of the first electrode 51 and the second electrode 52. In a state where the electrode unit 5 is disposed at the processing position, a surface 511 of the first electrode 51 facing downward is substantially parallel to the upper surface 91 of the substrate 9 and the surface 511 faces the peripheral portion 93 on the side of the upper surface 91 of the substrate 9. Further, a surface 521 of the second electrode 52 facing upward is substantially parallel to the lower surface 92 of the substrate 9 and the surface 521 faces the peripheral portion 93 on the side of the lower surface 92 of the substrate 9. In the following description, the surface 511 of the first electrode 51 and the surface 521 of the second electrode 52 are referred to as "facing surfaces 511 and 521". In the exemplary case shown in FIG. 3, both the facing surfaces 511 and 521 each have a circular shape. A power supply 50 is electrically connected to the first electrode 51 and the second electrode 52. During the etching of the peripheral portion 93, a predetermined voltage is applied to between the first electrode 51 and the second electrode 52.

As shown in FIG. 2, the processing liquid filling part 6 includes a processing liquid nozzle 61, a processing liquid line 62, and a processing liquid supply source 63. The processing liquid nozzle 61 is supported together with the electrode unit 5 by the electrode moving part 7. The processing liquid nozzle 61 is connected to the processing liquid supply source 63 through the processing liquid line 62. The processing liquid supply source 63 supplies a processing liquid to the processing liquid nozzle 61. The processing liquid line 62 is provided with a valve 621. As shown in FIG. 3, the processing liquid nozzle 61 is disposed inside in the radial direction relative to the first electrode 51 on the side of the upper surface 91 of the substrate 9. The processing liquid nozzle 61 is inclined with respect to the up-and-down direction so that a lower end thereof provided with a discharge port 611 is positioned outside in the radial direction relative to an upper end thereof. The discharge port 611 opens toward a gap between the first electrode 51 and the peripheral portion 93. During the etching of the peripheral portion 93, the processing liquid is discharged from the discharge port 611 toward the gap.

Typically, the processing liquid is an electrolyte solution, and for example, an aqueous solution containing hydrogen chloride (HCl), ammonium chloride (NH₄Cl), or the like as a solute. The concentration of the solute is, for example, not lower than 5 wt%, and preferably not lower than 10 wt%. The upper limit of the concentration of the solute is not particularly limited but is, for example, 25 wt%. The electrolyte solution may contain an additive or the like.

As shown in FIG. 2, the electrode moving part 7 includes a support part 71, an arm part 72, and an electrode moving mechanism 73. The support part 71 supports the processing liquid nozzle 61, the first electrode 51, and the second electrode 52. The processing liquid nozzle 61 and the electrode unit 5 are indirectly fixed to each other by the support part 71. The arm part 72 is a member extending in the radial direction. To one end of the arm part 72, the support part 71 is attached, and the other end thereof is supported by the electrode moving mechanism 73. The electrode moving mechanism 73 has, for example, a motor, a ball screw, and the like and can move the arm part 72 in the radial direction (a longitudinal direction of the arm part 72) and the up-and-down direction. In other words, the electrode moving mechanism 73 moves the electrode unit 5 and the processing liquid nozzle 61 in the radial direction and up-and-down direction. During the etching of the peripheral portion 93, the electrode unit 5 and the processing liquid nozzle 61 are disposed by the electrode moving mechanism 73 at the processing position which faces part (i.e., the target portion) of the peripheral portion 93 of the substrate 9. After the etching is completed, the electrode unit 5 and the processing liquid nozzle 61 are disposed at the escape position outside in the radial direction relative to the substrate 9. The electrode moving mechanism 73 may be implemented by a linear motor or the like.

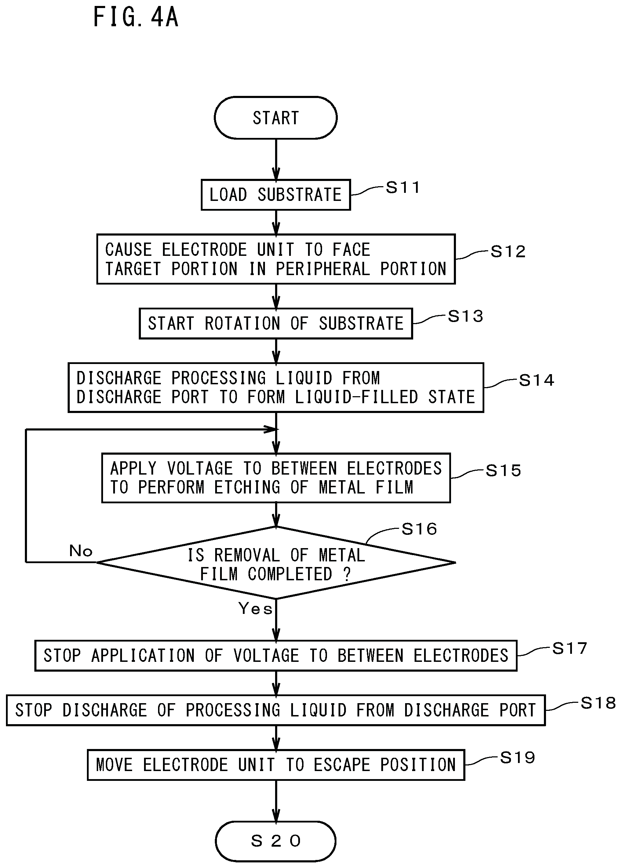

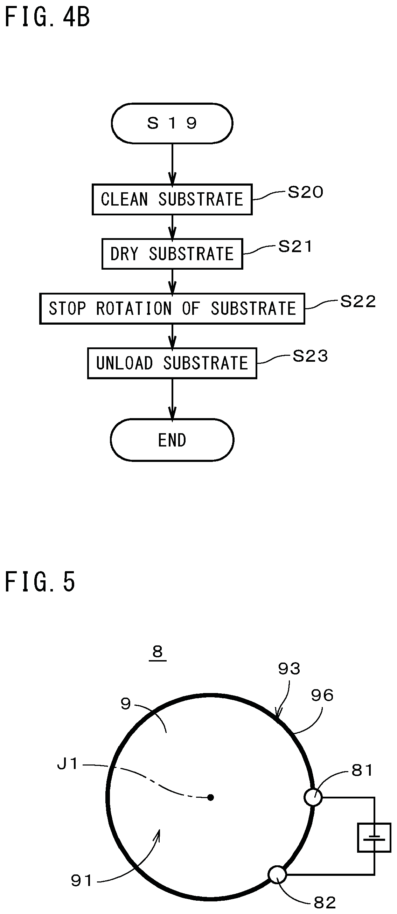

Next, an operation flow of processing the substrate 9 in the substrate processing apparatus 1 will be described, with reference to FIGs. 4A and 4B. During processing of the substrate 9, the controller 19 shown in FIG. 2 controls the constituent components. First, the substrate 9 on which the metal film 96 is formed is loaded into the substrate processing apparatus 1 and placed on the chuck part 21 (Step S11). The substrate 9 is held by the chuck part 21 through vacuum adsorption. At that time, the electrode unit 5 and the processing liquid nozzle 61 are disposed at the escape position at which loading/unloading of the substrate 9 is not inhibited. The same applies to the cleaning solution nozzle 31. Further, after the transfer of the substrate 9, like in Step S20 described later, a cleaning process (pre-cleaning) of the substrate 9 may be performed.

When the substrate 9 is held, the electrode moving mechanism 73 moves the arm part 72 to cause the electrode unit 5 and the processing liquid nozzle 61 to be disposed at the processing position. As shown in FIG. 3, the electrode unit 5 and the processing liquid nozzle 61 thereby face the target portion in the peripheral portion 93 of the substrate 9 (Step S12). At that time, a distance between each of the facing surface 511 of the first electrode 51 and the facing surface 521 of the second electrode 52, and the substrate 9 is adjusted in advance to become not longer than several mm. After that, the rotator 22 starts rotation of the substrate 9 at a predetermined rotation speed (Step S13).

Subsequently, by opening the valve 621, the processing liquid is discharged from the discharge port 611 of the processing liquid nozzle 61 toward the gap between the first electrode 51 and the peripheral portion 93. The processing liquid enters the gap between the first electrode 51 and the peripheral portion 93 and fills the gap. Part of the processing liquid may flow around the gap toward outside in the radial direction. The processing liquid also goes around to the side of the lower surface 92 of the peripheral portion 93 and also fills a gap between the second electrode 52 and the peripheral portion 93 by capillarity. Thus, formed is a liquid-filled state in which a space among the target portion, the first electrode 51, and the second electrode 52 is filled with the processing liquid (Step S14). In the liquid-filled state, the processing liquid continues among the target portion, the first electrode 51, and the second electrode 52 without interruption. Actually, on each of the upper surface 91 and the lower surface 92 of the substrate 9, the processing liquid is slightly spread from the gap between the electrodes 51 and 52 and the substrate 9 also inward in the radial direction. Further, only if the liquid-filled state can be maintained, the supply of the processing liquid from the processing liquid nozzle 61 to the peripheral portion 93 may be performed continuously or intermittently.

Subsequently, the power supply 50 applies a predetermined voltage to between the first electrode 51 and the second electrode 52. In the exemplary case shown in FIG. 3, the electric potential applied to the second electrode 52 is higher than that applied to the first electrode 51, and the first electrode 51 serves as a negative electrode and the second electrode 52 serves as a positive electrode. By applying the voltage to the electrode unit 5, etching of the metal film 96 at the target portion in the peripheral portion 93 is performed (Step S15). Actually, etching is performed preferentially on a portion of the metal film 96 which is in proximity to the negative electrode. Though the reason why the metal film 96 is etched is not necessarily clear, it is presumed that a chemical reaction described below, for example, occurs between the first electrode 51 and the second electrode 52.

In the facing surface 511 of the first electrode 51 (a region A1 in FIG. 3), a chemical reaction occurs as expressed below:

2H⁺ + 2e⁻ --> H₂ ... (1)

In the metal film 96 on the side of the first electrode 51 (a region A2 in FIG. 3), a chemical reaction occurs as expressed below:

Ru --> Ru³⁺ + 3e⁻ ... (2)

2Cl⁻ --> Cl₂ + 2e⁻ ... (3)

2H₂O --> O₂ + 4H⁺ + 4e⁻ ... (4)

The metal film 96 is thereby dissolved in the processing liquid.

In the metal film 96 on the side of the second electrode 52 (a region A3 in FIG. 3), a chemical reaction occurs as expressed below:

2H⁺ + 2e⁻ --> H₂ ... (5)

In the facing surface 521 of the second electrode 52 (a region A4 in FIG. 3), a chemical reaction occurs as expressed below:

2Cl⁻ --> Cl₂ + 2e⁻ ... (6)

2H₂O --> O₂ + 4H⁺ + 4e⁻ ... (7)

Further, in an experiment in which a space among the metal film, the first electrode, and the second electrode is filled with the processing liquid and a voltage is applied to the processing liquid through the first electrode and the second electrode, it is confirmed that the metal film is actually etched.

As described earlier, the substrate 9 is rotated relative to the electrode unit 5 and the target portion in the peripheral portion 93 is moved relative to the substrate 9 in the circumferential direction. Etching of the metal film 96 is thereby performed along the entire circumference of the peripheral portion 93. A not-shown imaging part is provided above the peripheral portion 93 of the substrate 9 and acquires an image of the peripheral portion 93 along the entire circumference. The image of the peripheral portion 93 is inputted to the controller 19, to thereby check a state of the peripheral portion 93. Specifically, it is checked whether or not the metal film 96 is removed from the peripheral portion 93 as a whole. Whether the metal film 96 is present or not in the peripheral portion 93 can be acquired by the well-known inspection algorithm. Whether the metal film 96 is present or not may be checked by any other method. For example, by measuring the current flowing between the second electrode 52 and the first electrode 51, whether the metal film 96 is present or not may be detected.

When the metal film 96 remains in the peripheral portion 93 (Step S16), the etching is continued. After the metal film 96 is removed from the peripheral portion 93 as a whole (Step S16), application of the voltage to between the electrodes 51 and 52 and the discharge of the processing liquid from the discharge port 611 of the processing liquid nozzle 61 are stopped (Steps S17 and S18). Subsequently, when the electrode moving mechanism 73 moves the arm part 72, the electrode unit 5 and the processing liquid nozzle 61 are moved away from the peripheral portion 93 to the escape position (Step S19). Further, the cleaning solution nozzle 31 is disposed at the supply position above the substrate 9. Then, the cleaning solution is supplied from the cleaning solution nozzle 31 toward a center portion of the upper surface 91 of the substrate 9. The cleaning solution is spread entirely the upper surface 91 of the substrate 9 and the cleaning process for washing away the processing liquid and the like adhering to the peripheral portion 93 of the substrate 9 is performed (Step S20). The cleaning solution is spattered outward in the radial direction from the peripheral portion 93 of the substrate 9 by the centrifugal force due to the rotation of the substrate 9 and collected by the cup 41. Furthermore, the cleaning solution nozzle 31 may discharge the cleaning solution toward the peripheral portion 93. Further, another nozzle for discharging the cleaning solution to the peripheral portion 93 on the side of the lower surface 92 may be provided.

After the cleaning process of the substrate 9 is performed for a predetermined time, the supply of the cleaning solution from the cleaning solution nozzle 31 to the substrate 9 is stopped. Subsequently, the rotation speed of the substrate 9 is increased and the cleaning solution on the substrate 9 is shaken off and removed. In other words, a drying process of the substrate 9 is performed (Step S21). After the drying process of the substrate 9 is completed, the rotation of the substrate 9 is stopped (Step S22). After that, the substrate 9 is unloaded from the substrate processing apparatus 1 (Step S23). By the above processes, processing of the substrate 9 in the substrate processing apparatus 1 is completed.

As described above, the substrate processing apparatus 1 shown in FIG. 2 includes the substrate holder (the chuck part 21 in the above-described case), the electrode unit 5, the processing liquid filling part 6, the rotator 22, and the power supply 50. The substrate holder holds the disk-like substrate. The electrode unit 5 faces the target portion which is part of the peripheral portion 93 of the substrate 9 during etching and has the first electrode 51 and the second electrode 52. The processing liquid filling part 6 forms the liquid-filled state in which the processing liquid fills a space among the target portion, the first electrode 51, and the second electrode 52 by discharging the processing liquid from the discharge port 611. The rotator 22 rotates the substrate 9 relative to the electrode unit 5, to thereby move the target portion in the peripheral portion 93 in the circumferential direction of the substrate 9. The power supply 50 applies a voltage to between the first electrode 51 and the second electrode 52. In the substrate processing apparatus 1, it is thereby possible to appropriately remove the metal film 96 in the peripheral portion 93 of the substrate 9.

Herein, a substrate processing apparatus of Comparative Example will be described. In a substrate processing apparatus 8 of Comparative Example shown in FIG. 5, like in the apparatus disclosed in Japanese Patent Application Laid Open Gazette No. 2021-158300 and Japanese Patent Application Laid Open Gazette No. 2023-8390 (Documents 3 and 4), a first electrode 81 comes into contact with the peripheral portion 93 of the substrate 9 through the processing liquid, and a second electrode 82 comes into contact with the peripheral portion 93 of the substrate 9 through the processing liquid at a position different from that of the first electrode 81. In other words, two different contacts are provided for the first electrode 81 and the second electrode 82. Herein, the first electrode 81 is a negative electrode and the second electrode 82 is a positive electrode. Further, the metal film 96 is circumferentially provided on the peripheral portion 93 and no metal film 96 is present inside relative to the peripheral portion 93.

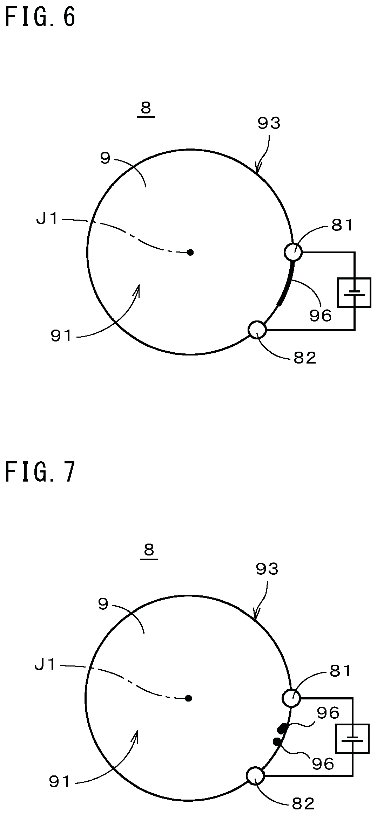

In the substrate processing apparatus 8 of Comparative Example, the metal film 96 is etched in the vicinity of the first electrode 81. Therefore, in a case where the metal film 96 is etched while the substrate 9 is rotated, when the etching proceeds to some degree, as shown in FIG. 6, the second electrode 82 faces a region in which the metal film 96 has been removed and the second electrode 82 is not electrically connected to the metal film 96. As a result, no current is carried between the first electrode 81 and the second electrode 82 and the etching does not proceed. Further, also in a case where the metal film 96 is scattered in the peripheral portion 93, as shown in FIG. 7, no current is carried between the first electrode 81 and the second electrode 82 and the etching cannot be performed.

In contrast to this, in the substrate processing apparatus 1 shown in FIG. 2, since the space among the target portion, the first electrode 51, and the second electrode 52 is filled with the processing liquid, the first electrode 51 and the second electrode 52 are electrically connected to the metal film 96 in the target portion substantially at one contact (through the same processing liquid). As a result, even in the case, as shown in FIG. 6, where the metal film 96 is interrupted or the case, as shown in FIG. 7, where an isolated metal film 96 is present, it is possible to appropriately remove the metal film 96. Further, in the substrate processing apparatus 1 in which the processing liquid is supplied only to one portion on the peripheral portion 93, it is possible to significantly reduce the amount of processing liquid to be consumed. Further, depending on the design of the substrate processing apparatus 1, there may be a configuration where another processing liquid nozzle for supplying the processing liquid to between the second electrode 52 and the substrate 9 is provided, as well as the above-described processing liquid nozzle 61, and the liquid-filled state can be thereby more reliably formed.

Preferably, the first electrode 51 positioned on the side of one main surface (the upper surface 91 in the above-described case) of the substrate 9 has the facing surface 511 substantially parallel to the one main surface and the facing surface 511 faces the substrate 9 on the side of the one main surface of the substrate 9. Further, the second electrode 52 positioned on the side of the other main surface (the lower surface 92 in the above-described case) of the substrate 9 has the facing surface 521 substantially parallel to the other main surface and the facing surface 521 faces the substrate 9 on the side of the other main surface of the substrate 9. Thus, since the first electrode 51 and the second electrode 52 have the facing surfaces 511 and 521, respectively, substantially parallel to the substrate 9, it is possible to easily bring each of the facing surfaces 511 and 521 closer to the substrate 9 and promote the reaction in the metal film 96 to thereby efficiently remove the metal film 96. Further, it is possible to easily hold the processing liquid between each of the facing surfaces 511 and 521 and the substrate 9.

Preferably, the processing liquid nozzle 61 in the processing liquid filling part 6 and the electrode unit 5 are (relatively) fixed to each other, and the electrode moving mechanism 73 moves the processing liquid nozzle 61 together with the electrode unit 5. It is thereby possible to simplify the configuration of the substrate processing apparatus 1 and reduce the manufacturing cost of the substrate processing apparatus 1, as compared with the case where a mechanism for moving the processing liquid nozzle 61 is separately provided. Further, depending on the design of the substrate processing apparatus 1, the mechanism for moving the processing liquid nozzle 61 may be separately provided, and respective positions of the electrode unit 5 and the processing liquid nozzle 61 inside the housing 11 may be fixed to thereby omit the electrode moving mechanism 73.

In the etching of the metal film 96 in the peripheral portion 93, as described earlier, a portion of the metal film 96 which is closer to the negative electrode is preferentially removed. In other words, it takes some time to remove a portion of the metal film 96 which is closer to the positive electrode. Therefore, depending on a position to which the metal film 96 adheres, it sometimes takes long time to remove the whole of the metal film 96 in the peripheral portion 93.

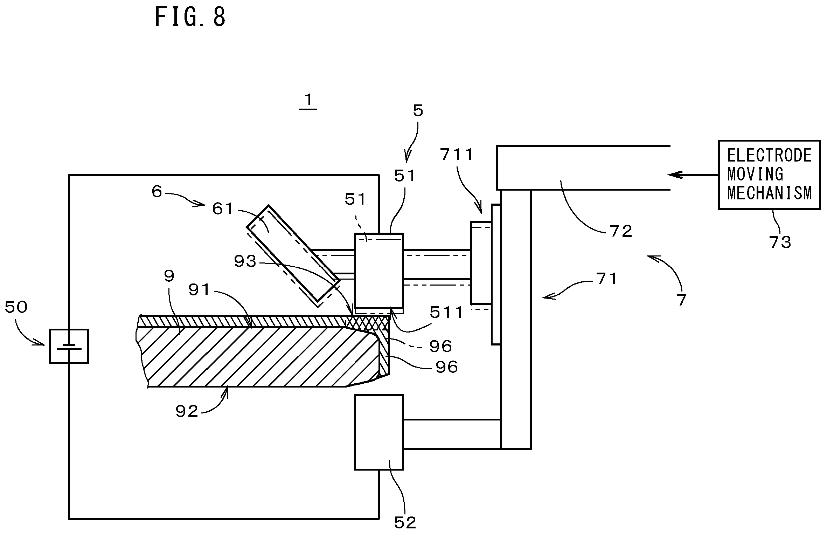

Next, a preferable method of efficiently remove the whole of the metal film 96 in the peripheral portion 93 will be described. FIG. 8 is a view showing another example of the substrate processing apparatus 1. In the substrate processing apparatus 1 shown in FIG. 8, in the support part 71 of the electrode moving part 7, provided is an auxiliary moving mechanism 711 for moving the processing liquid nozzle 61 and the first electrode 51 in a direction (the up-and-down direction herein) perpendicular to the substrate 9. The auxiliary moving mechanism 711 has, for example, a motor, a ball screw, and the like. The auxiliary moving mechanism 711 may be implemented by a linear motor or the like.

In the etching of the metal film 96 in the peripheral portion 93, when a portion (which is cross-hatched in FIG. 8) of the metal film 96 which is closer to the first electrode 51 which is a negative electrode is removed, as indicated by a two-dot chain line in FIG. 8, the first electrode 51 is slightly moved toward the side of the substrate 9 by the auxiliary moving mechanism 711. A distance between the facing surface 511 of the first electrode 51 and the metal film 96 remaining in the peripheral portion 93 (i.e., the metal film 96 except the crossed-hatched portion) is thereby reduced to be shorter, and it becomes possible to reduce the time required to remove the whole of the metal film 96 in the peripheral portion 93.

At that time, when the auxiliary moving mechanism 711 moves the processing liquid nozzle 61 together with the first electrode 51, even in a state where the first electrode 51 is brought closer to the remaining metal film 96, it is possible to supply the processing liquid to an appropriate position between the first electrode 51 and the substrate 9. Depending on the design of the substrate processing apparatus 1, the auxiliary moving mechanism 711 may move only the first electrode 51. The timing when the auxiliary moving mechanism 711 brings the first electrode 51 closer to the substrate 9 is determined, for example, on the basis of the image of the peripheral portion 93 acquired by the imaging part. This timing may be determined on the basis of the current flowing between the second electrode 52 and the first electrode 51 or may be a time set in advance.

Further, instead of movement of the first electrode 51 by the auxiliary moving mechanism 711 or as well as movement of the first electrode 51, the power supply 50 may increase the voltage to be applied to between the first electrode 51 and the second electrode 52. It is thereby possible to promote removal of a portion of the metal film 96 which is away from the first electrode 51. Further, after removing a portion of the metal film 96 which is closer to the first electrode 51 which is a negative electrode, the power supply 50 may reverse the negative electrode and the positive electrode (reverse the polarity of the first electrode 51 and that of the second electrode 52). The first electrode 51 thereby becomes a positive electrode and the second electrode 52 becomes a negative electrode. As a result, etching of a portion of the metal film 96 which is closer to the second electrode 52 which has become the negative electrode is promoted, and it becomes possible to reduce the time required to remove the whole of the metal film 96 in the peripheral portion 93 (i.e., etching time). The above-described method of reducing the etching time may be adopted in any other preferred embodiment.

In the substrate processing apparatus 1, it is also possible to adjust the width of a range in the radial direction, in which the metal film 96 is removed in the peripheral portion 93. Specifically, in the electrode moving mechanism 73 for moving the arm part 72, the position of the electrode unit 5 in the radial direction can be changed, and in the controller 19, an input of a radial position at which the electrode unit 5 should be disposed is received and set. In order to cause the electrode unit 5 to face the target portion in the peripheral portion 93 in Step S12 in FIG. 4A, by the control of the controller 19, the electrode unit 5 is disposed at the radial position which is set. In the etching of the metal film 96 in Step S15, a portion of the metal film 96 which almost faces the facing surface 511 of the first electrode 51 is removed. As described earlier, since the processing liquid filling between the facing surface 511 and the substrate 9 is slightly spread, due to the surface tension, inside in the radial direction relative to an inner edge of the first electrode 51, a portion of the metal film 96 which is slightly inside relative to the first electrode 51 is also etched.

Thus, the preferable substrate processing apparatus 1 includes the electrode moving mechanism 73 for moving the electrode unit 5 in the radial direction of the substrate 9. It is thereby possible to adjust the radial position of the electrode unit 5 and adjust the etching width (removal width) of the metal film 96 in the radial direction. Further, when the electrode moving mechanism 73 moves the processing liquid nozzle 61 together with the electrode unit 5, also after the electrode unit 5 is moved, it is possible to supply the processing liquid to an appropriate position between the first electrode 51 and the substrate 9.

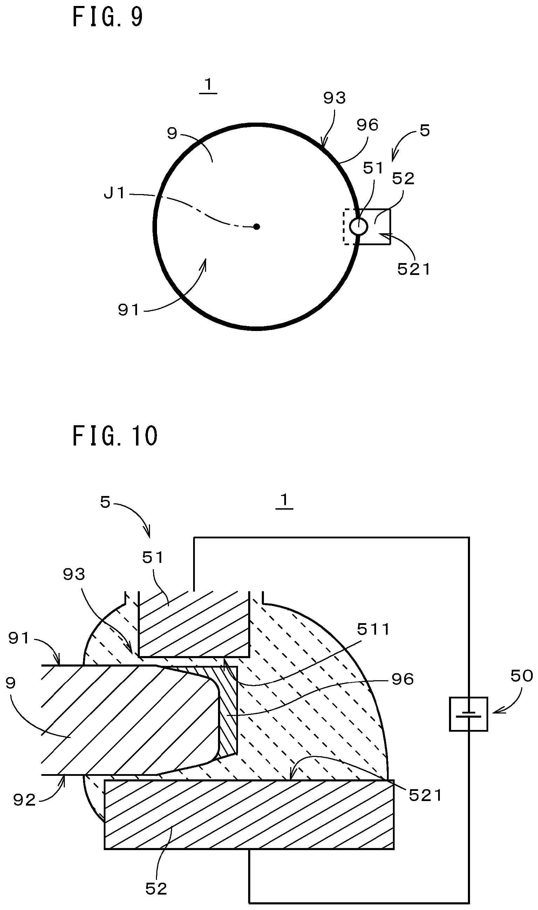

FIGs. 9 and 10 are views each showing another example of the electrode unit 5. FIG. 9 is a plan view of the electrode unit 5, and FIG. 10 is a cross-sectional view of the electrode unit 5. In the electrode unit 5 shown in FIGs. 9 and 10, the second electrode 52 positioned on the side of the lower surface 92 of the substrate 9 has a rectangular plate-like shape. A surface of the second electrode 52, facing upward, is the facing surface 521 facing the substrate 9 and substantially parallel to the lower surface 92 of the substrate 9. The facing surface 521 of the second electrode 52 is larger than the facing surface 511 of the first electrode 51. The area of the facing surface 521 is, for example, twice or more that of the facing surface 511, and preferably three times or more. The upper limit of the area of the facing surface 521 is not particularly limited, but since the weight of the second electrode 52 increases when the facing surface 521 becomes excessively larger, the area of the facing surface 521 is, for example, ten times or less that of the facing surface 511. In a plan view, the whole of the first electrode 51 overlaps the whole of the second electrode 52.

Thus, since the facing surface 521 of the second electrode 52 positioned on the side of the lower surface 92 of the substrate 9 is larger than the facing surface 511 of the first electrode 51 positioned on the side of the upper surface 91 of the substrate 9, it is possible to increase the retentiveness of the processing liquid on the second electrode 52. As a result, it becomes possible to easily maintain the liquid-filled state in which the processing liquid fills a space among the target portion of the peripheral portion 93, the first electrode 51, and the second electrode 52. Further, since the facing surface 521 of the second electrode 52 which is the positive electrode is larger, the reduction reaction in the facing surface 521 is promoted as compared with the electrode unit 5 shown in FIG. 3. The oxidation reaction in the facing surface 511 of the first electrode 51 is thereby also promoted, and an increase in the etching rate of the metal film 96 is achieved.

In the substrate processing apparatus 1, for example, in a case where the metal film 96 in the peripheral portion 93 is positioned on the side of the lower surface 92, such as a case where the substrate 9 is held with a surface downward, on which a wiring pattern is formed, in the electrode unit 5 shown in FIGs. 9 and 10, the first electrode 51 may serve as the positive electrode and the second electrode 52 may serve as the negative electrode. Also in this case, it is possible to promote the oxidation reaction in the facing surface 521 of the second electrode 52 and promote the reduction reaction in the facing surface 511 of the first electrode 51.

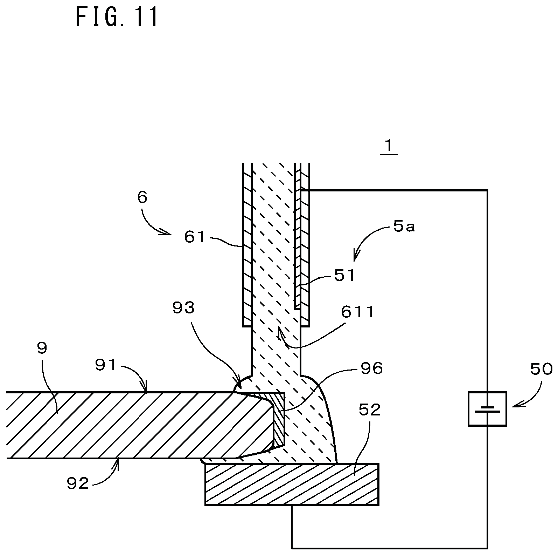

FIG. 11 is a cross-sectional view showing an electrode unit 5a and the processing liquid nozzle 61 in the substrate processing apparatus 1 in accordance with the second preferred embodiment. In the substrate processing apparatus 1 shown in FIG. 11, a configuration of the electrode unit 5a and the processing liquid nozzle 61 is different from that in the substrate processing apparatus 1 shown in FIG. 2 and the other constituent elements are identical to those shown in FIG. 2. The processing liquid nozzle 61 is a straight nozzle which is oriented in the up-and-down direction, and in a state where the processing liquid nozzle 61 is disposed at the processing position, the processing liquid nozzle 61 is disposed above the peripheral portion 93 of the substrate 9. The processing liquid nozzle 61 is formed of, for example, an insulating material such as a resin or the like. The first electrode 51 in the electrode unit 5a is a film formed of a conductive material, which is provided on an inner surface of the processing liquid nozzle 61. In other words, the processing liquid nozzle 61 is a nozzle with built-in electrode. Like in the exemplary case shown in FIG. 10, the second electrode 52 has a plate-like shape. The power supply 50 is connected to the first electrode 51 and the second electrode 52.

In the etching of the metal film 96 in the peripheral portion 93 of the substrate 9, the processing liquid is continuously discharged from the discharge port 611 of the processing liquid nozzle 61. The processing liquid covers the metal film 96 in the target portion of the peripheral portion 93 and collides with the second electrode 52. In other words, a liquid column of the processing liquid formed downward from the discharge port 611 comes into contact with both the target portion of the peripheral portion 93 and the second electrode 52. Actually, the processing liquid also goes around to the side of the lower surface 92 of the peripheral portion 93 and fills the gap between the second electrode 52 and the peripheral portion 93. Thus, the liquid-filled state in which the processing liquid fills the space among the target portion, the first electrode 51, and the second electrode 52 is maintained. The power supply 50 applies the voltage to between the first electrode 51 and the second electrode 52, to thereby etch the metal film 96.

Thus, in the substrate processing apparatus 1 shown in FIG. 11, the processing liquid filling part 6 is disposed on the side of the upper surface 91 of the substrate 9 and includes the processing liquid nozzle 61 having the discharge port 611. The processing liquid nozzle 61 discharges the processing liquid from the discharge port 611 toward the target portion. The first electrode 51 is disposed inside the processing liquid nozzle 61, and the second electrode 52 is disposed on the side of the lower surface 92 of the substrate 9. Also in the substrate processing apparatus 1 shown in FIG. 11, it is possible to appropriately remove the metal film 96 in the peripheral portion 93 of the substrate 9. Further, the electrode moving mechanism 73 adjusts the respective radial positions of the processing liquid nozzle 61 and the electrode unit 5a, to thereby adjust the etching width of the metal film 96 in the radial direction. Further, in the exemplary case shown in FIG. 11, the processing liquid nozzle 61 may be movable in the radial direction, independently of the second electrode 52.

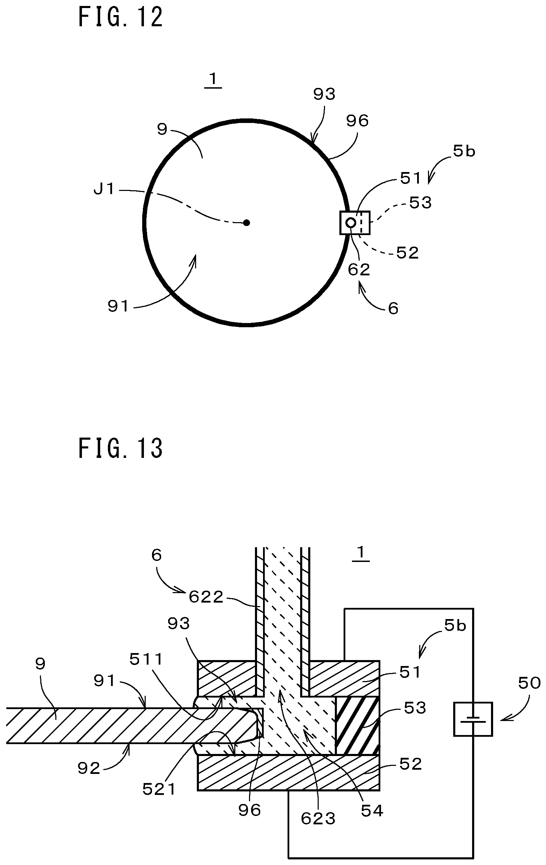

FIGs. 12 and 13 are views each showing an electrode unit 5b and part of the processing liquid filling part 6 in the substrate processing apparatus 1 in accordance with the third preferred embodiment. FIG. 12 is a plan view showing the electrode unit 5b and the like, and FIG. 13 is a cross-sectional view showing the electrode unit 5b and the like. In the substrate processing apparatus 1 shown in FIGs. 12 and 13, a configuration of the electrode unit 5b and part of the processing liquid filling part 6 is different from that in the substrate processing apparatus 1 shown in FIG. 2 and the other constituent elements are identical to those shown in FIG. 2.

The electrode unit 5b shown in FIGs. 12 and 13 includes the rectangular plate-like first electrode 51 and the rectangular plate-like second electrode 52. In a state where the electrode unit 5b is disposed at the processing position, the first electrode 51 is positioned on the side of the upper surface 91 of the substrate 9 and the second electrode 52 is positioned on the side of the lower surface 92 of the substrate 9. The surface of the first electrode 51 facing downward is the facing surface 511 facing the substrate 9 and substantially parallel to the upper surface 91 of the substrate 9. The surface of the second electrode 52 facing upward is the facing surface 521 facing the substrate 9 and substantially parallel to the lower surface 92 of the substrate 9. The facing surface 511 of the first electrode 51 and the facing surface 521 of the second electrode 52 are substantially parallel to each other. The distance between the first electrode 51 and the second electrode 52 is slightly larger than the thickness of the substrate 9.

The electrode unit 5b further includes an insulating member 53. The insulating member 53 has a block-like shape, which is formed of, for example, a resin, and is disposed between an outer end of the first electrode 51 and an outer end of the second electrode 52 in the radial direction. The first electrode 51 and the second electrode 52 are fixed to the insulating member 53. A through hole is provided in the first electrode 51 inside in the radial direction relative to the insulating member 53. In the processing liquid line 62 (see FIG. 2) of the processing liquid filling part 6, a connecting member 622 is provided at an end opposite to the processing liquid supply source 63, and the connecting member 622 is inserted into the through hole of the first electrode 51 and fixed. The connecting member 622 has a discharge port 623 of the processing liquid, and the processing liquid is supplied from the discharge port 623 into a space 54 (hereinafter, referred to as a "processing space 54" surrounded by the insulating member 53, the first electrode 51, and the second electrode 52. In the substrate processing apparatus 1 shown in FIG. 13, the connecting member 622. the first electrode 51, the insulating member 53, and the second electrode 52 are integrally configured as a unit and movable by the electrode moving mechanism 73.

In the etching of the peripheral portion 93 of the substrate 9, when the electrode unit 5b and the connecting member 622 are disposed at the processing position, the peripheral portion 93 is inserted into the processing space 54 from inside in the radial direction. The processing liquid is discharged from the discharge port 623 of the connecting member 622 and the processing space 54 is filled with the processing liquid. In other words, the liquid-filled state in which the processing liquid fills a space among the target portion in the peripheral portion 93, the first electrode 51, and the second electrode 52 is formed. Then, the power supply 50 applies the voltage to between the first electrode 51 and the second electrode 52, to thereby etch the metal film 96. Further, only if the liquid-filled state can be maintained in the processing space 54, the discharge of the processing liquid from the discharge port 623 may be performed continuously or intermittently.

Thus, in the substrate processing apparatus 1 shown in FIG. 13, the electrode unit 5b has the insulating member 53 which is disposed between the first electrode 51 and the second electrode 52 outside relative to the peripheral portion 93 of the substrate 9 and to which the first electrode 51 and the second electrode 52 are fixed. The processing liquid filling part 6 supplies the processing liquid from the discharge port 623 to the processing space 54 surrounded by the insulating member 53, the first electrode 51, and the second electrode 52. It is thereby possible to easily and more reliably form the liquid-filled state and appropriately remove the metal film 96 in the peripheral portion 93.

Further, the member (the connecting member 622 in the above-described case) having the discharge port 623 in the processing liquid filling part 6 and the electrode unit 5b are fixed to each other, and the electrode moving mechanism 73 moves the above-described member together with the electrode unit 5b. It is thereby possible to simplify the configuration of the substrate processing apparatus 1. Further, the electrode moving mechanism 73 adjusts the radial position of the electrode unit 5b, to thereby adjust the etching width of the metal film 96 in the radial direction.

In the above-described substrate processing apparatus 1, various modifications can be made.

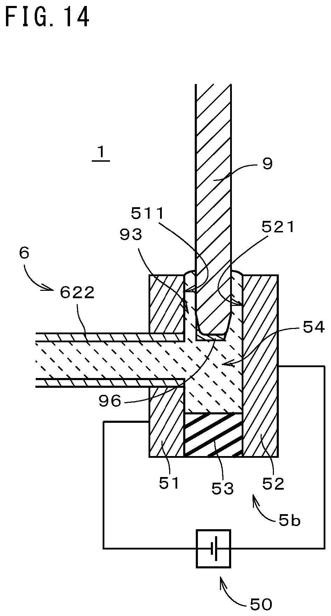

The substrate 9 does not necessarily need to be held in the horizontal posture but may be held, for example, in an upright position as shown in FIG. 14. In this case, the central axis J1 of the spin chuck 2 is oriented in a substantially horizontal direction. In the exemplary case shown in FIG. 14, the first electrode 51 has the facing surface 511 which faces one main surface of the substrate 9 and which is substantially parallel to the one main surface. Further, the second electrode 52 has the facing surface 521 which faces the other main surface of the substrate 9 and which is substantially parallel to the other main surface. It is thereby possible to dispose the peripheral portion 93 of the substrate 9 between the first electrode 51 and the second electrode 52 while bringing each of the facing surfaces 511 and 521 closer to the substrate 9 and increase the etching rate of the metal film 96.

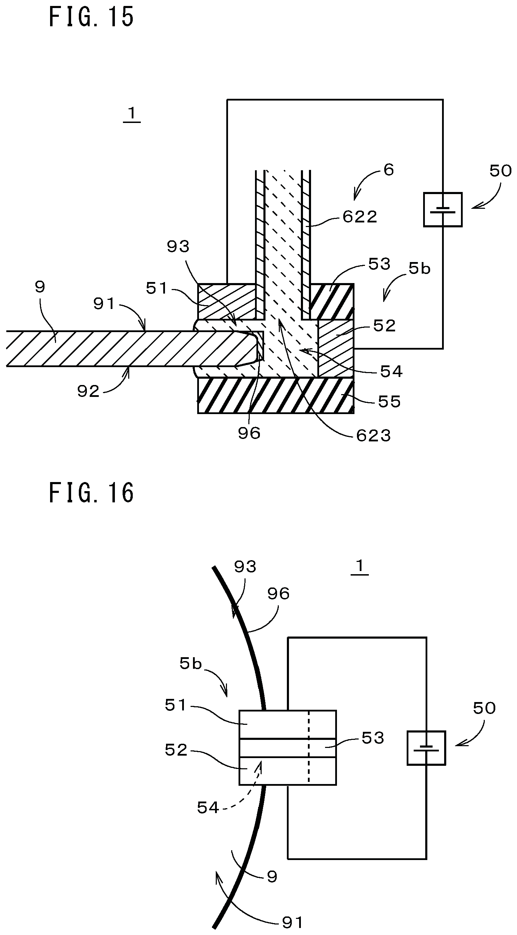

As shown in FIG. 15, the first electrode 51 may be positioned on the side of one main surface of the substrate 9 (for example, on the side of the upper surface 91), and the second electrode 52 may be positioned outside in the radial direction relative to the substrate 9. In the exemplary case shown in FIG. 15, the first electrode 51 and the insulating member 53 are provided on the side of the one main surface and the other rectangular plate-like insulating member 55 is positioned on the side of the other main surface of the substrate 9. The first electrode 51, the insulating member 53, the second electrode 52, and the insulating member 55 form the processing space 54.

Further, as shown in FIG. 16, on the side of one main surface of the substrate 9 (for example, the side of the upper surface 91), the first electrode 51, the insulating member 53, and the second electrode 52 may be provided in line in the circumferential direction. In the exemplary case shown in FIG. 16, insulating members cover a portion in the peripheral portion 93 of the substrate 9 outside in the radial direction and another portion thereof on the side of the other main surface, and these insulating members, the first electrode 51, the insulating member 53, and the second electrode 52 form the processing space 54. The discharge port 623 of the connecting member 622 is provided, for example, on the insulating member on the side of the other main surface.

In any one of the cases shown in FIGs. 15 and 16, by supplying the processing liquid from the discharge port 623 into the processing space 54, the processing liquid fills a space among the target portion in the peripheral portion 93, the first electrode 51, and the second electrode 52. Then, by applying the voltage to between the first electrode 51 and the second electrode 52, it is possible to remove the metal film 96 in the peripheral portion 93.

On the other hand, in order to increase the etching rate of the metal film 96 in the peripheral portion 93, like the electrode unit 5, 5a, or 5b shown in FIG. 3, 8, 10, 11, 13 or 14, it is preferable that the first electrode 51 should be positioned on the side of one main surface of the substrate 9 and the second electrode 52 should be positioned on the side of the other main surface of the substrate 9. Thus, since the substrate 9 is disposed between the first electrode 51 and the second electrode 52, it is possible to efficiently remove the metal film 96. In the above-described electrode unit 5, 5a, or 5b, as viewed along a direction perpendicular to the substrate 9, though substantially the whole of the first electrode 51 overlaps the second electrode 52, the first electrode 51 and the second electrode 52 may only partially overlap each other. In the substrate processing apparatus 1, as viewed along the direction perpendicular to the substrate 9, since the first electrode 51 and the second electrode 52 at least partially overlap each other, it becomes possible to efficiently remove the metal film 96.

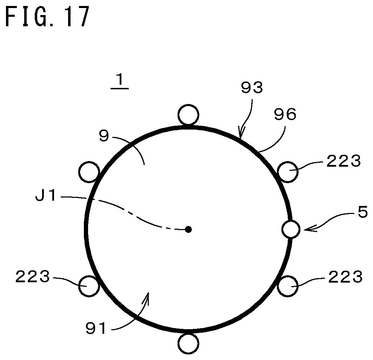

The substrate holder for holding the substrate 9 and the rotator for rotating the substrate 9 may be any configuration other than the chuck part 21 and the rotator 22 shown in FIG. 2, respectively. As shown in FIG. 17, there may be a configuration, for example, where a plurality of rollers 223 are arranged in the circumferential direction around the substrate 9 and come into contact with the edge end surface or the like of the substrate 9 to hold the substrate 9 while some of the rollers 223 rotate on their own axes to rotate the substrate 9 around the central axis J1. Further, depending on the design of the substrate processing apparatus 1, the electrode unit 5, 5a, or 5b (and the processing liquid nozzle 61 and the connecting member 622) may be rotated around the central axis J1 without rotating the substrate 9. The rotator in the substrate processing apparatus 1 has only to rotate the substrate 9 relative to the electrode unit 5, 5a, or 5b.

The substrate to be processed in the substrate processing apparatus 1 is not limited to a semiconductor substrate but may be a glass substrate or any other substrate.

The configurations in the above-described preferred embodiments and variations may be combined as appropriate only if those do not conflict with one another.

While the invention has been shown and described in detail, the foregoing description is in all aspects illustrative and not restrictive. It is therefore understood that numerous modifications and variations can be devised without departing from the scope of the invention.

### REFERENCE SIGNS LIST

- 1: Substrate processing apparatus
- 5, 5a, 5b: Electrode unit
- 6: Processing liquid filling part
- 9: Substrate
- 21: Chuck part
- 22: Rotator
- 50: Power supply
- 51: First electrode
- 52: Second electrode
- 53: Insulating member
- 61: Processing liquid nozzle
- 73: Electrode moving mechanism
- 91: Upper surface (of substrate)
- 92: Lower surface (of substrate)
- 93: Peripheral portion (of substrate)
- 96: Metal film
- 511, 521: Facing surface (of electrode)
- 611, 623: Discharge port
- 622: Connecting member

## Claims

1. A substrate processing apparatus for performing etching on a peripheral portion of a substrate, comprising:
a substrate holder for holding a disk-like substrate;
an electrode unit facing a target portion during etching, and having a first electrode and a second electrode, said target portion being part of said peripheral portion of said substrate;
a processing liquid filling part for forming a liquid-filled state in which a processing liquid fills a space among said target portion, said first electrode, and said second electrode by discharging said processing liquid from a discharge port;
a rotator for rotating said substrate relative to said electrode unit, to thereby move said target portion in said peripheral portion in a circumferential direction of said substrate; and
a power supply for applying a voltage to between said first electrode and said second electrode.

2. The substrate processing apparatus according to claim 1, wherein
said first electrode is positioned on a side of one main surface of said substrate and said second electrode is positioned on a side of the other main surface of said substrate.

3. The substrate processing apparatus according to claim 2, wherein
said first electrode and said second electrode at least partially overlap each other as viewed along a direction perpendicular to said substrate.

4. The substrate processing apparatus according to claim 2, wherein
said first electrode has a facing surface substantially parallel to said one main surface and said facing surface of said first electrode faces said substrate on the side of said one main surface of said substrate, and
said second electrode has a facing surface substantially parallel to said other main surface and said facing surface of said second electrode faces said substrate on the side of said other main surface of said substrate.

5. The substrate processing apparatus according to claim 4, wherein
said substrate is held in a horizontal posture by said substrate holder, and
said facing surface of said second electrode positioned on a lower surface side of said substrate is larger than said facing surface of said first electrode positioned on an upper surface side of said substrate.

6. The substrate processing apparatus according to claim 5, wherein
said second electrode is a positive electrode.

7. The substrate processing apparatus according to claim 4, wherein
said electrode unit has an insulating member to which said first electrode and said second electrode are fixed, said insulating member being disposed between said first electrode and said second electrode outside said peripheral portion of said substrate, and
said processing liquid filling part supplies said processing liquid from said discharge port to a space surrounded by said insulating member, said first electrode, and said second electrode.

8. The substrate processing apparatus according to claim 1, wherein
said substrate is held in a horizontal posture by said substrate holder,
said processing liquid filling part comprises a nozzle having said discharge port, being disposed on an upper surface side of said substrate,
said nozzle discharges said processing liquid from said discharge port toward said target portion, and
said first electrode is disposed inside said nozzle and said second electrode is disposed on a lower surface side of said substrate.

9. The substrate processing apparatus according to any one of claims 1 to 8, further comprising:
an electrode moving mechanism for moving said electrode unit in a radial direction of said substrate.

10. The substrate processing apparatus according to claim 9, wherein
a member having said discharge port in said processing liquid filling part and said electrode unit are fixed to each other, and
said electrode moving mechanism moves said member of said processing liquid filling part together with said electrode unit.
